# EUROPÄISCHE PATENTANMELDUNG

(11) **EP 0 898 217 A2**
(43) Veröffentlichungstag der Anmeldung: **24.02.1999**
(21) Anmeldenummer: 98113568.4
(22) Anmeldetag: 20.07.1998
(51) Int. Cl.: G06F 1/08

(54) **Schaltung zur glitchfreien Umschaltung digitaler Signale**

(30) Priorität: 06.08.1997 DE 19734028
(71) Anmelder: SIEMENS AKTIENGESELLSCHAFT, 80333 München (DE)
(72) Erfinder: Sandner, Christophe, 9500 Villach (AT)

(57) **Zusammenfassung**

Es ist eine Schaltung zur glitchfreien Umschaltung digitaler Signale offenbart, die einen Multiplexer mit einer Vielzahl von Signaleingangsanschlüssen, Signalwählanschlüssen und einem Signalausgangsanschluß aufweist, und darüber hinaus einen Anschluß für die Schaltungsausgabe aufweist. Die Schaltung ist gekennzeichnet durch eine Zählerlogik zum Zählen von Impulsen im Ausgangssignal des Multiplexers und zum Abgeben eines Zählsignals bei Erreichen eines bestimmten Zählwertes und durch eine Verzögerungslogik zum Verzögern eines Multiplexer-Wählsignals und zum Abgeben eines Schaltsignals und eines verzögerten Multiplexer-Wählsignals. Während eines gesetzten Schaltsignals ist die Zählerlogik aktiviert und die Schaltungsausgabe ist deaktiviert.

## Beschreibung

Die Erfindung betrifft eine Schaltung zur glitchfreien Umschaltung digitaler Signale nach dem Oberbegriff von Patentanspruch 1.

In Frequenzsynthesizern oder Microcontrollern mit interner Takterzeugung mittels PLL (phase locked loop) besteht häufig die Notwendigkeit, einen Ausgangstakt der Schaltung zwischen mehreren Frequenzen umschaltbar zu machen. Dazu wird in der Schaltung gewöhnlich ein Multiplexer verwendet, an dessen Eingängen jeweils unterschiedliche Taktsignale anliegen. Am Multiplexer kann gewählt werden, welches der Eingangssignale an den Ausgang geführt wird. Zu diesem Zweck weist der Multiplexer entsprechende Signalwählanschlüsse auf. In manchen Fällen muß gewährleistet sein, daß beim Umschalten von einem ersten Eingangssignal auf ein zweites Eingangssignal des Multiplexers, d. h. beim Umschalten von einer ersten Taktrate auf eine zweite Taktrate, keine Taktperiode auftritt, die kürzer als die minimal zulässige Taktperiode ist. Eine derartige unzulässige Taktperiode wird in der Technik mit 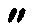 Glitch" bezeichnet. Ein derartig kurzer Impuls kann zu einer unkontrollierten Fehlfunktion der mit dem Ausgangstakt des Multiplexers angesteuerten, nachfolgenden Schaltung führen, insbesondere dann, wenn dieser Takt der Systemtakt eines Microcontrollers ist.

Die Entstehung von Glitches und deren unerwünschte Folgen sind beispielsweise in dem Fachbuch von Paul Horowitz mit dem Titel 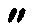 The Art of Electronics", erschienen in 2. Auflage 1989 bei Cambridge University Press, Seiten 515 ff, erläutert. Im dortigen Kapitel 8.19 sind Synchronisierer beschrieben, mit denen die Probleme, die durch Glitches hervorgerufen sind, weitgehend vermieden werden können. In dem Fachbuch von Carver A. Mead mit dem Titel 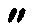 Introduction to VLSI-Systems", erschienen 1980 bei Addison-Wesley, ist im Kapitel 7.5, 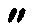 Synchronisation Failure" von Seite 236 bis 242 ebenfalls die Thematik mangelnder Synchronisierung und deren Folgen behandelt. Auf diese Veröffentlichungen wird im Hinblick auf die Erläuterung des Begriffes 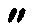 Glitches" vollinhaltlich Bezug genommen.

Das der Erfindung zugrundeliegende technische Problem besteht daher darin, eine Schaltung anzugeben, mit der zwischen einer Vielzahl digitaler Signale ohne Glitches umgeschaltet werden kann.

Dieses Problem wird gelöst durch eine Schaltung mit den Merkmalen von Patentanspruch 1. Bevorzugte Ausführungsformen dieser Schaltung sind in den Unteransprüchen angegeben.

In einer Ausführungsform weist die Schaltung nach der Erfindung einen Multiplexer mit einer Vielzahl von Signaleingangsanschlüssen auf. An jedem der Signaleingangsanschlüsse kann ein digitales Signal angelegt werden. Bei den digitalen Signalen handelt es sich vorzugsweise um Taktsignale mit voneinander unterschiedlicher Taktrate. Der Multiplexer weist darüber hinaus Signalwählanschlüsse auf, an denen digitale Signale anlegbar sind, die festlegen, welches der Vielzahl von Eingangssignalen ausgewählt wird, um durch den Multiplexer ausgegeben zu werden. Der Multiplexer weist demnach einen Signalausgangsanschluß auf, an den das ausgewählte Signal ausgegeben wird. Die Schaltung ist unter anderem gekennzeichnet durch eine Zählerlogik, die die im Ausgangssignal des Multiplexers enthaltenen Impulse zählt und bei Erreichen eines bestimmten Zählwertes eine Zählsignal abgibt. Vorzugsweise erfolgt die Zählung von Impulsen anhand der ansteigenden Signalflanke. Die Schaltung ist ferner gekennzeichnet durch eine Verzögerungslogik, die ein eingehendes Wählsignal für den Multiplexer verzögert und ein Schaltsignal und ein verzögertes Wählsignal für den Multiplexer abgibt, wobei während eines gesetzten Schaltsignals die Zählerlogik aktiviert und die dem Ausgangsanschluß den Multiplexers nachgeordnete Schaltungsausgabe deaktiviert ist.

Dabei wird das Schaltsignal infolge einer Änderung des Multiplexer-Wählsignals gesetzt. Nach Setzen des Schaltsignals nimmt die Zählerlogik den Zählbetrieb auf, und nachdem ein bestimmter Zählwert erreicht ist, gibt die Zählerlogik ein Zählsignal ab. Daraufhin wird die Verzögerungslogik veranlaßt, das Schaltsignal rückzusetzen, das beim Setzen die zuvor an die Schaltung angelegte Änderung des Multiplexer-Wählsignals schließlich mit verzögerter Wirkung direkt an den Multiplexer anlegt.

Es ist besonders bevorzugt, daß die Verzögerungslogik eine Vielzahl von in Reihe geschalteten, einflankengetriggerten D-Flipflops aufweist. Die Flipflops sind jeweils mit dem Ausgangssignal des Multiplexers getaktet. Der Q-Ausgang eines D-Flipflops ist jeweils mit dem D-Eingang des in der Reihenschaltung nachfolgenden Flipflops verbunden. Am D-Anschluß des ersten Flipflops liegt ein Signal an, das anzeigt, daß sich das Multiplexer-Wählsignal gerade geändert hat, und am Q-Anschluß des n-ten Flipflops wird das Schaltsignal abgegeben. Durch die Verzögerungsschaltung wird erreicht, daß eine Änderung in der Wahl eines der Signaleingangsanschlüsse mit einer Verzögerung an den Multiplexer angelegt wird. Dabei ist besonders bevorzugt, daß die Verzögerungslogik genau zwei D-Flipflops aufweist.

Es ist ferner bevorzugt, daß die Zählerlogik einen Einbit-Zähler aufweist. Bei einem Einbit-Zähler wird der Zählwert bereits nach einer Taktperiode erreicht, woraufhin dieser das Zählsignal abgibt. Dabei ist besonders bevorzugt, daß die Zählerlogik ein D-Flipflop aufweist, durch das das Ausgangs-Signal des Einbit-Zählers um eine zusätzliche Taktperiode verzögert wird. Dadurch wird sichergestellt, daß ein im Einbit-Zähler eventuell auftretender metastabiler Zustand nicht zu einer vorzeitigen Ausgabe des Zählsignals führen kann.

Weitere Vorteile, Merkmale und Anwendungsmöglichkeiten der vorliegenden Erfindung ergeben sich aus der nachfolgenden Beschreibung eines Ausführungsbeispiels in Verbindung mit der Zeichnung. In der Zeichnung zeigen:
Figur 1 ein Blockschaltbild einer Schaltung nach einem bevorzugten Ausführungsbeispiel der Erfindung;
Figur 2 ein bevorzugtes Ausführungsbeispiel der Verzögerungslogik und
Figur 3 ein bevorzugtes Ausführungsbeispiel der Zählerlogik.

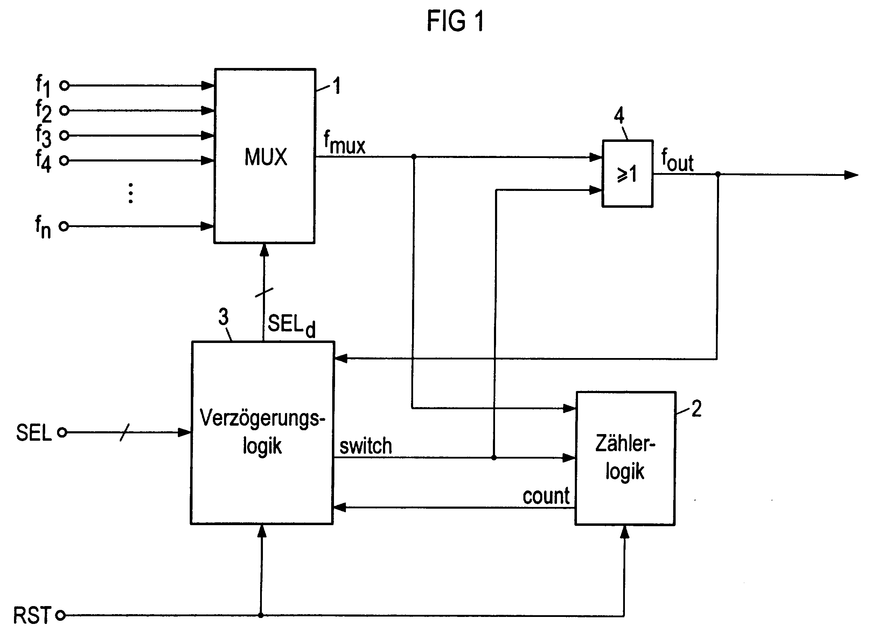

Im bevorzugten Ausführungsbeispiel der Schaltung nach Figur 1 ist ein Multiplexer 1, eine Zählerlogik 2 und eine Verzögerungslogik 3 dargestellt. Dem Multiplexer 1 wird eine Vielzahl von Signalen f₁, f₂, fᵢ, ... fₙ zugeführt, bei denen es sich typischerweise um Taktsignale mit unterschiedlicher Taktrate handelt. Der Multiplexer 1 weist einen einzigen Ausgangsanschluß auf, an dem ein Signal fₘᵤₓ abgreifbar ist, das aus der Vielzahl der Eingangssignale f₁, f₂, ... fₙ ausgewählt ist. Die Auswahl erfolgt durch ein Signal SEL_{d}, das dem Multiplexer von der Verzögerungslogik 3 zugeführt wird. Beim Multiplexer-Wählsignal SEL_{d} handelt es sich typischerweise um ein Digitalsignal, das auf mehrere physikalische Leitungen aufgeteilt ist, die zusammenfassend als Bus bezeichnet sind und in Figur 1 durch einen Schrägstrich auf der das Signal SEL_{d} führenden Leitung dargestellt sind.

Der Zählerlogik 2 wird das Ausgangssignal fₘᵤₓ des Multiplexers 1 als Taktsignal zugeführt. Der Zählerlogik 2 wird ferner von der Verzögerungslogik 3 ein Schaltsignal switch zugeführt, das den Zählerbetrieb freigibt, wenn es gesetzt ist. Die Zählerlogik 2 weist darüber hinaus einen Ausgangsanschluß auf, an dem ein Zählsignal count abgegeben wird. Dieses Zählsignal count zeigt das Erreichen eines bestimmten Zählwertes an. Schließlich weist die Zählerlogik 2 einen Eingangsanschluß zum Zuführen eines Rücksetzsignals RST auf, wodurch der Zählerstand auf einen Ausgangszustand rückgesetzt werden kann.

Die Verzögerungslogik 3 weist Eingangsanschlüsse zum Zuführen von Wählsignalen SEL, anhand derer die Auswahl eines Eingangssignals aus der Vielzahl von Eingangssignalen f₁, f₂, ... , fₙ des Multiplexers 1 erfolgt. Das Multiplexer-Wählsignal SEL wird, wie das bereits erwähnte verzögerte Multiplexer-Wählsignal SEL_{d}, durch einen digitalen Signalbus im bevorzugten Ausführungsbeispiel dargestellt. Die Verzögerungslogik 3 empfängt das Multiplexer-Wählsignal SEL und gibt es verzögert als verzögertes Multiplexer-Wählsignal SEL_{d} an den Multiplexer 1 aus. Die Verzögerungslogik 3 gibt nach einer Änderung des Multiplexer-Wählsignals SEL das Schaltsignal switch an die Zählerlogik 2 aus.

Das Schaltsignal switch wird ferner einem ODER-Gatter 4 zugeführt, dem auch das Ausgangssignal fₘᵤₓ des Multiplexers zugeführt wird. Das Ausgangssignal des ODER-Gatters 4 fₒᵤₜ entspricht dem Ausgangssignal fₘᵤₓ des Multiplexers 1, wenn das Schaltsignal switch nicht gesetzt ist, d. h. einen niedrigen Pegel aufweist, und entspricht dem Schaltsignal switch, wenn dieses gesetzt ist, d. h. auf einem hohen Pegel liegt.

Die Verzögerungslogik 3 wird durch das Ausgangssignal fₒᵤₜ des ODER-Gatters 4, das zugleich das Ausgangssignal der Schaltung ist, getaktet. Das Schaltsignal switch wird rückgesetzt, wenn die Verzögerungslogik 3 das Zählsignal count von der Zählerlogik 2 empfängt oder wenn ein externes Rücksetzsignal empfangen wird.

Der Schaltung liegt folgender Ablauf zugrunde: Die Änderung des Multiplexer-Wählsignals SEL wird registriert und nach Ablauf einer bestimmten Anzahl von Taktperioden des Ausgangs-signals fₒᵤₜ durch Setzen des Schaltsignals switch der Zählerlogik 2 und dem ODER-Gatter 4 signalisiert. Durch Setzen des Schaltsignals switch wird das Ausgangssignal fₘᵤₓ des Multiplexers 1, das vor diesem Zeitpunkt als Ausgangssignal fₒᵤₜ der Schaltung durch das ODER-Gatter 4 durchgereicht wurde, maskiert, so daß das Ausgangssignal fₒᵤₜ der Schaltung auf einem hohen Pegel verbleibt und damit der Verzögerungslogik 3 keine weiteren Taktsignale zugeführt werden. Durch Setzen des Schaltsignals switch wird die Zählerlogik 2 in Betrieb gesetzt, die vom Ausgangssignal fₘᵤₓ des Multiplexers 1 getaktet wird. Gleichzeitig veranlaßt das Setzen des Schaltsignals switch, daß das geänderte Multiplexer-Wählsignal SEL als verzögertes Multiplexer-Wählsignal SEL_{d} an den Multiplexer 1 durchgereicht wird und dieser somit sein Ausgangssignal fₘᵤₓ entsprechend dem nunmehr gewählten Eingangssignal fⱼ ändert. Da sich das verzögerte Multiplexer-Wählsignal SEL_{d} asynchron mit den Eingangssignalen f₁, f₂, ..., fₙ des Multiplexers 1 ändert, kann es zum Zeitpunkt des Umschaltens zu undefinierten Signalzuständen am Ausgang des Multiplexers 1 kommen, die bei einer nachfolgenden Schaltung als mehrfache Taktflanken interpretiert werden könnten und somit Fehler verursachen könnten. Da jedoch zum Zeitpunkt des Umschaltens das Schaltsignal switch bereits gesetzt ist, können diese als Glitches bezeichneten Fehlsignale nicht im Ausgangssignal fₒᵤₜ der Schaltung erscheinen, da das Ausgangssignal fₘᵤₓ des Multiplexers 1 durch das ODER-Gatter 4 vom Schaltsignal switch maskiert ist.

Die Zählerlogik 2, die den Zählbetrieb mit gesetztem Schaltsignal switch aufnimmt, zählt nunmehr das vom Multiplexer 1 abgegebene Ausgangssignal fₘᵤₓ das in diesem Zeitraum die erwähnten Glitches enthalten kann. Nach Erreichen eines bestimmten Zählwertes, der so bemessen ist, daß sich zu diesem Zeitpunkt das Ausgangssignal fₘᵤₓ des Multiplexers 1 ohne Glitches stabilisiert hat, gibt die Zählerlogik 2 das Zählsignal count aus, womit die Verzögerungslogik 3 rückgesetzt wird und das Schaltsignal somit wieder abfällt. Da die Zählerlogik 2 mit dem Ausgangssignal fₘᵤₓ getaktet ist, ist sichergestellt, daß beim Rücksetzen des Schaltsignals switch und damit der Wegnahme der Maskierung durch das ODER-Gatter 4 im Ausgangssignal fₒᵤₜ der Schaltung keine Glitches mehr auftreten.

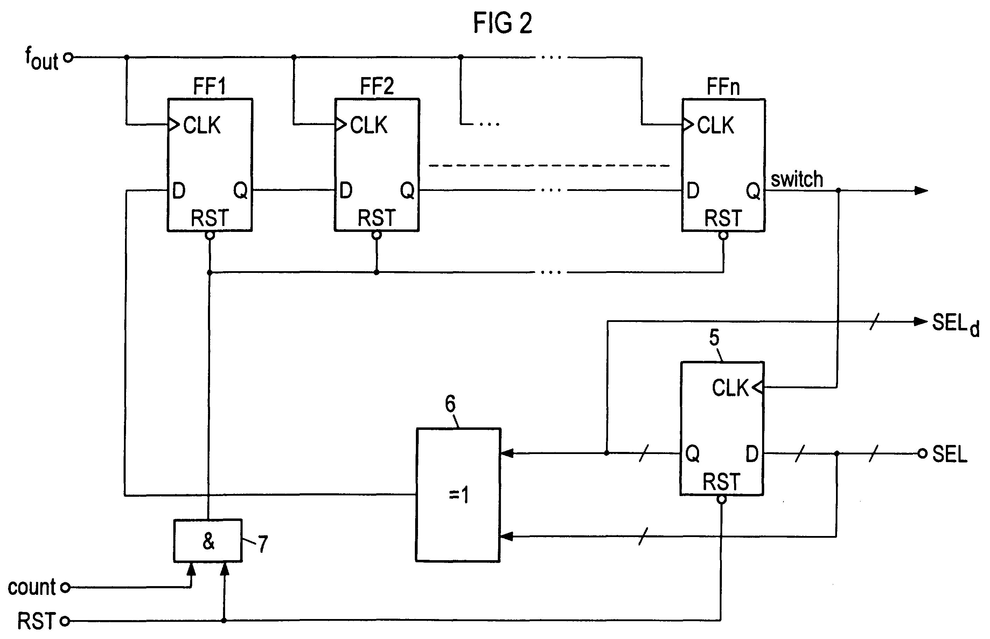

Figur 2 zeigt die Ausgestaltung der Verzögerungslogik 3 gemäß dem bevorzugten Ausführungsbeispiel. Die Verzögerungslogik 3 weist demnach eine Reihenschaltung aus einer Vielzahl von einflankengetriggerten D-Flipflops FF1, FF2, ...,FFn auf, die im folgenden nur noch als Flipflops bezeichnet werden. Die Flipflops FF1, FF2, ..., FFn sind alle vom Ausgangssignal fₒᵤₜ der Schaltung getaktet. Die Flipflops FF1, FF2, ...,FFn sind so in Reihe geschaltet, daß der Q-Ausgang eines Flipflops mit dem D-Eingang des in der Reihenschaltung nachfolgenden Flipflops verbunden ist. Am Q-Ausgang des letzten Flipflops FFn ist das Schaltsignal switch abgreifbar.

Die Verzögerungslogik 3 weist ein weiteres D-Flipflop 5 auf, das mit dem Schaltsignal switch getaktet ist. Tatsächlich besteht das Flipflop 5 aus einer Parallelschaltung von m-Flipflops entsprechend der Anzahl der Leitungen auf dem Bus für das Multiplexer-Wählsignal SEL. Zur Vereinfachung wird jedoch mit dem Bezugszeichen 5 im weiteren nur ein Flipflop bezeichnet, das stellvertretend für alle m Flipflops, die für die jeweilige Anzahl von Busleitungen erforderlich sind, steht. Am Q-Ausgang des Flipflops 5 ist das verzögerte Multiplexer-Wählsignal SEL_{d} abgreifbar. Das Ausgangssignal des Flipflops 5 wird darüber hinaus einem kombinierten EXOR-Gatter 6 mit zweimal m Eingangsanschlüssen zugeführt. Die verbleibenden m Eingangsanschlüsse des EXOR-Gatters werden durch das Multiplexer-Wählsignal SEL gebildet. Am Ausgangsanschluß des EXOR-Gatters 6 liegt ein Signal an, das immer dann gesetzt ist, wenn sich das Multiplexer-Wählsignal SEL und das verzögerte Multiplexer-Wählsignal SEL_{d} an irgendeiner Busleitung unterscheiden. Da im stationären Zustand das Multiplexer-Wählsignal SEL und das verzögerte Multiplexer-Wählsignal SEL_{d} identisch sind, wird durch ein gesetztes Ausgangssignal am EXOR-Gatters 6 eine Änderung im Multiplexer-Wählsignal SEL angezeigt.

Der Ausgangsanschluß des EXOR-Gatters 6 ist mit dem D-Anschluß des ersten Flipflops FF1 der Reihenschaltung von Flipflops FF1, FF2, ..., FFn verbunden. Somit wird eine Änderung des Multiplexer-Wählsignals SEL nach n Taktperioden des Ausgangssignals fₒᵤₜ der Schaltung durch Setzen des Schaltsignals switch angezeigt.

Die Reihenschaltung der Flipflops FF1, FF2, ...,FFn wird durch Setzen des Zählsignals count rückgesetzt. Das Zählsignal count ist im gesetzten Zustand auf einem niedrigen Pegel. Es wird an einem UND-Gatter 7 mit einem externen Rücksetzsignal RST verknüpft, das ebenfalls im gesetzten Zustand auf einem niedrigen Pegel liegt. Das Ausgangssignal des UND-Gatters 7 ist mit allen Rücksetzeingängen der Reihenschaltung von Flipflops FF1, FF2, ..., FFn verbunden. Die Reihenschaltung der Flipflops wird somit rückgesetzt, wenn entweder das Zählsignal count oder das Rücksetzsignal RST gesetzt wird, wodurch das Schaltsignal switch rückgesetzt wird. Das externe Rücksetzsignal RST ist im übrigen mit dem Rücksetzeingang des Flipflops 5 verbunden.

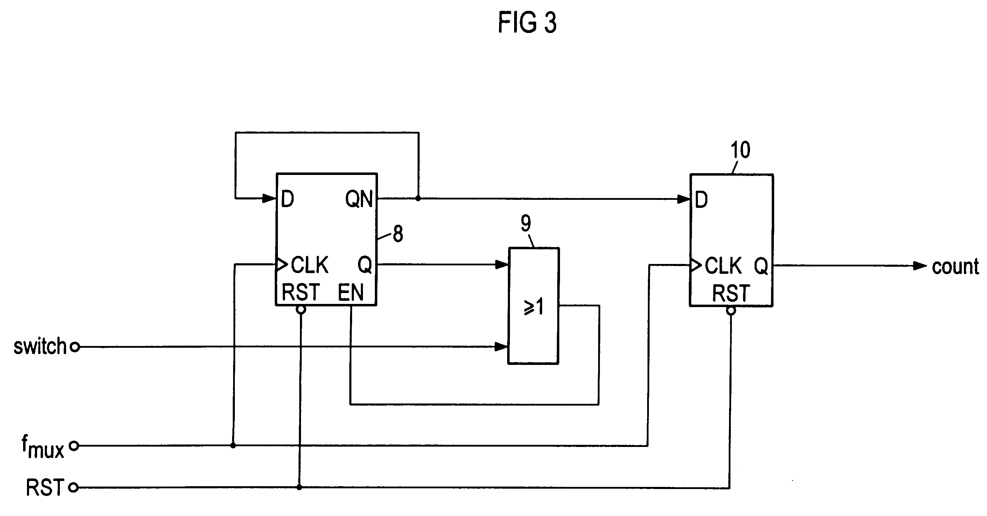

Figur 3 zeigt die Ausgestaltung der Zählerlogik 2 gemäß dem bevorzugten Ausführungsbeispiel. Es ist dabei ein Einbit-Zähler vorgesehen, der durch ein D-Flipflop 8 gebildet ist. Das D-Flipflop 8 wird vom Ausgangssignal fₘᵤₓ des Multiplexers 1 getaktet. Der negierte Q-Ausgangsanschluß QN ist mit dem Eingangsanschluß D des Flipflops 8 verbunden, was zu einer Halbierung der Eingangstaktfrequenz fₘᵤₓ am Ausgang des Flipflops 8 führt. Das Flipflop 8 weit darüber hinaus einen Freigabeanschluß EN auf, an den über das ODER-Gatter 9 das Schaltsignal switch, das im gesetzten Zustand auf einem hohen Pegel liegt, geführt wird. Ein weiterer Eingangsanschluß des ODER-Gatters 9 ist mit dem Ausgangsanschluß Q des Flipflops 8 verbunden, so daß das Flipflop 8 auch schalten kann, wenn das Schaltsignal switch wieder rückgesetzt ist und der Q-Ausgangsanschluß des Flipflops 8 gerade auf einem hohen Pegel liegt.

Der invertierte Ausgangsanschluß QN des Flipflops 8 ist mit dem Eingangsanschluß D eines Flipflops 10 verbunden, das das Ausgangssignal des Zählers um einen weiteren Takt des Taktsignals fₘᵤₓ puffert. Am Ausgangsanschluß Q des Flipflops 10 kann das Zählsignal count abgegriffen werden. Das Flipflop 8 und das Flipflop 10 können, in ähnlicher Weise wie die in Figur 2 dargestellten Flipflops, durch ein externes Rücksetzsignal RST rückgesetzt werden.

Das Problem der Umschaltung zwischen einer Vielzahl von Taktsignalen wurde bisher nur durch Verwendung eines Multiplexers gelöst. Dabei ist allerdings eine glitchfreie Umschaltung nur zwischen synchronen Signalen möglich, und die Umschaltung selbst muß ebenfalls synchron erfolgen. Wird beispielsweise von einem ersten Takt, der gerade auf einem niedrigen Pegel liegt, auf einen zweiten Takt geschaltet, der gerade auf einem hohen Pegel liegt, so entsteht am Ausgang des Multiplexers eine ansteigende Flanke, die in keinem der beiden Taktsignale vorhanden war. Auch wenn beide Taktsignale auf einem hohen Pegel liegen, kann es bei bestimmten Multiplexer-Architekturen beim Umschalten zu Glitches kommen. Ursache dafür sind static race hazards durch unterschiedliche Verzögerungen in den Auswahlleitungen. Eine glitchfreie Umschaltung zwischen asynchronen Signalen ist mit einem herkömmlichen Multiplexer nicht möglich.

Die Schaltung nach der Erfindung setzt einen herkömmlichen digitalen Multiplexer zur Umschaltung ein und verwendet darüber hinaus eine zusätzliche Logik, die einen glitchfreien Schaltvorgang sowohl synchroner als auch asynchroner Digitalsignale sicherstellt. Auch die Multiplexer-Wählsignale können asynchron geschaltet werden. Eventuell auftretende metastabile Zustände an den Flipflops aufgrund eines Zusammentreffens asynchroner Signale werden durch synchronisierende Flipflops, wie etwa die Reihenschaltung der Vielzahl von Flipflops FF1, FF2, ..., FFn und das Flipflop 10 der Zählerlogik 2, aufgefangen und pflanzen sich damit innerhalb der Schaltung nicht fort. Die Schaltung kann im übrigen durch Anlegen eines asynchronen externen Rücksetzsignals RST rückgesetzt werden.

## Patentansprüche

1. Schaltung zur glitchfreien Umschaltung digitaler Signale mit einem Multiplexer (1), der eine Vielzahl von Signaleingangsanschlüssen (f₁, f₂, ... fₙ), Signalwählanschlüsse (SEL_{d}) und einen Signalausgangsanschluß (fₘᵤₓ) aufweist, und einem Anschluß für die Schaltungsausgabe (fₒᵤₜ),
**gekennzeichnet durch**
eine Zählerlogik (2) zum Zählen von Impulsen im Ausgangssignal (fₘᵤₓ) des Multiplexers und zum Abgeben eines Zählsignals (count) bei Erreichen eines bestimmten Zählwertes und eine Verzögerungslogik (3) zum Verzögern eines Multiplexer-Wählsignals (SEL) und zum Abgeben eines Schaltsignals (switch) und eines verzögerten Multiplexer-Wählsignals (SEL_{d}), wobei während eines gesetzten Schaltsignals (switch) die Zählerlogik (2) aktiviert und die Schaltungsausgabe (fₒᵤₜ) deaktiviert ist.

2. Schaltung nach Patentanspruch 1,
**dadurch gekennzeichnet**, daß
das Schaltsignal (switch) nach einer Änderung des Multiplexer-Wählsignals (SEL) gesetzt wird und nach Erreichen des Zählwertes rückgesetzt wird.

3. Schaltung nach einem der Patentansprüche 1 oder 2,
**dadurch gekennzeichnet**, daß
die Verzögerungslogik (3) eine Vielzahl von in Reihe geschalteten, einflankengetriggerten D-Flipflops (FF1, FF2, ... FFn) aufweist, die jeweils mit dem Ausgangssignal (fₘᵤₓ) des Multiplexers (fₘᵤₓ) getaktet sind, wobei am D-Anschluß des ersten Flipflops (FF1) ein Signal anliegt, das anzeigt, daß sich das Multiplexer-Wählsignal (SEL) gerade geändert hat, und am Q-Anschluß des n-ten Flipflops (FFn) das Schaltsignal (switch) abgegeben wird.

4. Schaltung nach Patentanspruch 3,
**dadurch gekennzeichnet**, daß
die Verzögerungslogik (3) zwei D-Flipflops aufweist.

5. Schaltung nach einem der vorhergehenden Patentansprüche,
**dadurch gekennzeichnet**, daß
die Zählerlogik einen Einbit-Zähler (8) aufweist.

6. Schaltung nach Patentanspruch 5,
**dadurch gekennzeichnet**, daß
die Zählerlogik ein D-Flipflop (10) aufweist, das durch Impulse im Ausgangssignal des Multiplexers (1) getaktet wird und das das Ausgangssignal des Einbit-Zählers (8) verzögert.
